# EUROPÄISCHE PATENTANMELDUNG

(11) **EP 1 109 214 A1**
(43) Veröffentlichungstag der Anmeldung: **20.06.2001**
(21) Anmeldenummer: 99125114.1
(22) Anmeldetag: 16.12.1999
(51) Int. Cl.: H01L 21/60, H01L 21/607

(54) **Anordnung und Verfahren zur Kontaktierung von Schaltkreisen**

(71) Anmelder: Infineon Technologies AG, 81541 München (DE)
(72) Erfinder: Lehner, Rudolf, 93083 Niedertraubling (DE)
(74) Vertreter: Zedlitz, Peter, Dipl.-Inf.

(57) **Zusammenfassung**

Die vorliegende Erfindung betrifft eine Anordnung und ein Verfahren zum Kontaktieren von Schaltkreisen mit einem Schaltkreis (1), einem Träger (2), der neben dem Schaltkreis (1) angeordnet ist, einem Setzelement (5), an der eine elektrische Verbindung (3) aus einem leitenden Material (6) angeordnet ist, so daß die elektrische Verbindung (3) in einem Bond-Prozeß den Schaltkreis (1) mit dem Träger (2) verbindet.

## Beschreibung

Die vorliegende Erfindung betrifft eine Anordnung und ein Verfahren zum Kontaktieren von Schaltkreisen.

Schaltkreise und integrierte Schaltungen werden zu ihrer Weiterverarbeitung mit einem Trägermaterial kontaktiert und in Gehäuse verpackt.

Das Kontaktieren mit einem Trägermaterial ist z.B. aus der Druckschrift GB-A-2177639 bekannt. Dort wird ein integrierter Schaltkreis mittels eines Ultraschall-Draht-Bonders (Wire-Bonder) mit einem Trägermaterial kontaktiert. Bei dem Trägermaterial handelt es in dieser Druckschrift um einen Leadframe. Eine weitere Druckschrift zu Wire-Bonding ist das US Patent 5,395,038.

Bei einem Wire-Bonder wird ein langer Draht (sogenannter Endlosdraht) verwendet, der sich auf einer Spule befindet. Das Verarbeitungsende des Endlosdrahtes wird durch die Bond-Maschine gefädelt und mit einer Kanüle an die zu kontaktierende Position herangefahren.

Beim sogenannten Ball-Bonden wird mittels Temperatur und Ultraschall das Verarbeitungsende des Endlosdrahtes aufgeschmolzen und mit dem Kontaktpad des integrierten Schaltkreises, das sich auf dem integrierten Schaltkreis befindet, verbunden und bildet dabei eine Kugel, woraus der Name Ball-Bonden abgeleitet ist. Anschließend wird mit der Kanüle und dem darin befindlichen Bond-Draht eine Position auf dem Leadframe angefahren und der Bond-Draht wird mit dem Leadframe verbunden. Nun wird der Bond-Draht durchgetrennt und die Kanüle mit dem Bond-Draht fährt die nächste Position zur Bildung einer elektrischen Verbindung an.

Ein weiteres Verfahren zur Kontaktierung integrierter Schaltkreise ist das sogenannte Wedge-Wedge-Bonden. Dabei wird der Bond-Draht nicht mit Temperatur aufgeschmolzen, sondern mit einem Stempel, der sich an einer Seite der Kanüle befindet, angepreßt bzw. angerieben.

Nachteilig an beiden Verfahren ist die Verwendung eines Bond-Drahtes, da dieser meist aus Gold hergestellt wird und daher teuer ist. Bei dicken Bond-Drähten ist der Goldpreis der größte Kostenfaktor, bei dünnen Bond-Drähten ist die Fertigungstechnik zur Erzeugung eines konformen, dünnen und homogenen Drahtes der größte Kostenfaktor.

Weiterhin ist es nachteilig, daß bei dem Wire-Bonden immer nur eine Bond-Verbindung zur Zeit in sukzessiver Abfolge angefertigt werden kann. Dies führt bei integrierten Schaltkreisen mit 1000 und mehr Kontakten zu einer langen Fertigungszeit, die die Kosten nach oben treibt.

Die lange Fertigungszeit kann mit der sogenannten Flip-Chip-Technik, die z.B. in dem US-Patent 4,887,758 beschrieben wird, verkürzt werden. Dazu wird ein Leadframe verwendet, dessen elektrische Leitungen so angeordnet sind, daß sie exakt bis zu den elektrischen Kontaktpads des integrierten Schaltkreises heranreichen. Dort werden die elektrischen Leitungen des Leadframes in einem Prozeß gleichzeitig auf alle Kontaktpads des integrierten Schaltkreises gedrückt und verbunden.

Die Flip-Chip-Technik hat allerdings den Nachteil, daß nur ein Chip mit dem Leadframe verbunden werden kann. Oftmals werden aber zwei oder mehr Einzelchips in einem Gehäuse verpackt und elektrisch kontaktiert. Die Flip-Chip-Technik ist dann nicht in der Lage, eine elektrische Verbindung zwischen zwei Chips in einem Gehäuse herzustellen.

Es ist die Aufgabe der vorliegenden Erfindung, eine Anordnung und ein Verfahren zur Kontaktierung von integrierten Schaltkreisen zu schaffen, das die gleichzeitige Kontaktierung aller elektrischen Kontakte ermöglicht.

Erfindungsgemäß wird die Aufgabe durch ein Verfahren zum Kontaktieren eines Schaltkreises mit dem Schritt: anordnen eines Trägers (2) neben einem Schaltkreis (1) gelöst, welches dadurch gekennzeichnet ist, daß ein Setzelement (5), an dem eine elektrische Verbindung (3) aus einem leitenden Material (6) haftet, an den Schaltkreis (1) und an den Träger (2) angenähert wird, so daß die elektrische Verbindung (3) den Schaltkreis (1) und den Träger (2) elektrisch verbindet.

Der Vorteil der Erfindung besteht darin, daß mindestens zwei Bond-Verbindungen gleichzeitig in einem Bond-Prozeß den Schaltkreis mit dem Träger verbinden können. Bestenfalls können sogar alle Bond-Verbindungen gleichzeitig gebildet werden.

Ein weiterer Vorteil der Erfindung besteht in der Möglichkeit, elektrischen Verbindungen zwischen zwei integrierten Schaltkreisen zu bilden, die in einem Gehäuse angeordnet sind. Ebenfalls ist es möglich, die Substrate zweier integrierter Schaltkreise übereinander anzuordnen und die elektrischen Verbindungen zwischen den integrierten Schaltkreisen zu bilden. Auch diese Bond-Prozesse sind parallel in einem Schritt ausgeführbar.

Besonders vorteilhaft an der Lösung der Aufgabe ist die Verwendung eines Gußverfahrens zur Bildung der Bond-Verbindungen. Dabei können Bond-Verbindungen, die große Ströme zu tragen haben, breiter und dicker ausgeführt werden, als dijenigen, die geringe Lasten zu tragen haben. Außerdem entfällt die kostenintensive Herstellung eines Bond-Drahtes.

Durch dieses Verfahren wird die gleichzeitige Kontaktierung von mehr als einem elektrischen Kontakt zwischen dem Träger und dem integrierten Schaltkreis oder zwischen zwei in einem Gehäuse zu verpackenden integrierten Schaltkreisen auf separaten Chips ermöglicht, wenn an dem Setzelement eine weitere elektrische Verbindung angeordnet ist.

In einer besonders vorteilhaften Ausführung der Erfindung sind alle elektrischen Verbindungen zwischen dem Schaltkreis und dem Träger an dem Setzelement angeordnet, so daß sie gleichzeitig in einem Bond-Prozeß den Schaltkreis und den Träger verbinden können. Durch dieses Verfahren wird eine enorme Zeitersparnis gegenüber Wire-Bonding erzielt, die sich in einer Kostenreduktion niederschlägt.

In einer weiteren vorteilhaften Ausprägung der Erfindung ist das leitende Material in einer Gußform angeordnet, wobei ein Teil der Gußform aus dem Setzelement besteht. Durch diese Anordnung ist es möglich, die elektrischen Verbindungen zwischen dem Schaltkreis und dem Träger in der Gußform zu gießen, und die Gußform später so zu öffnen, daß die leitenden Verbindungen vorerst an dem Setzelement verbleiben.

In einer weiteren vorteilhaften Ausprägung der erfindungsgemäßen Anordnung besteht das leitende Material zumindest teilweise aus Gold, Kupfer und/oder Aluminium. Dadurch ist es möglich, Metalle und metallische Legierungen zu verwenden, die nicht ausschließlich aus kostenintensivem Gold bestehen, sondern auch aus günstigerem hochleitfähigem Kupfer oder Aluminium hergestellt sind. Üblicherweise tritt bei dem Versuch, Bond-Drähte aus Kupfer herzustellen, das Problem auf, daß Kupfer oxidiert, bevor es eine elektrische Verbindung herstellen kann. Diesem Problem kann mit der Ummantelung von Kupfer mit Gold bei der Bond-Draht-Herstellung begegnet werden. Allerdings ist das Ummantelungsverfahren aufwendig und teuer.

Erfindungsgemäß wird die Aufgabe weiterhin durch die in Anspruch 6 angegebene Anordnung gelöst.

In einer weiteren vorteilhaften Ausprägung des erfindungsgemäßen Verfahrens wird in die Gußform, die mindestens aus zwei Formteilen besteht, wobei es sich bei einem der Formteile um das Setzelement handelt, in ihre Formteile zerlegt, wobei die elektrische Verbindung an dem Setzelement verbleibt. Durch dieses Verfahren wird das Gießen der elektrischen Verbindungen und das Trennen der Gußform ermöglicht, wobei die elektrischen Verbindungen direkt an den vorgesehenen Positionen in der Setzmatrix entstehen.

In einer weiteren vorteilhaften Ausprägung des erfindungsgemäßen Verfahrens werden die elektrischen Verbindungen zwischen dem Schaltkreis und dem Träger mittels Andrücken des Setzelements, mittels Ultraschall und/oder mittels Temperatur hergestellt. Dieses Verfahren hat den Vorteil, daß die elektrischen Verbindungen direkt an den für sie vorgesehenen Positionen mit dem Schaltkreis und mit dem Träger verbunden werden.

In einer weiteren vorteilhaften Ausprägung des erfindungsgemäßen Verfahrens wird das Setzelement nach dem Bond-Prozeß von dem Schaltkreis und dem Träger entfernt. Bei diesem Prozeß verbleiben die elektrischen Verbindungen zwischen dem Schaltkreis und dem Träger, und das Setzelement löst sich von den elektrischen Verbindungen und wird von dem Schaltkreis und dem Träger entfernt.

Ausführungsbeispiele der vorliegenden Erfindung sind in den Zeichnungen dargestellt und nachfolgend näher erläutert.

### Es zeigen:

- Figur 1: Ein Ausführungsbeispiel des erfindungsgemäßen Bond-Prozesses;
- Figur 2: Einen nach Figur 1 folgenden Schritt des Ausführungsbeispiels eines erfindungsgemäßen Bond-Prozesses;
- Figur 3: Eine Draufsicht auf eine Anordnung mit Schaltkreis, Träger und Bond-Verbindungen;
- Figur 4: Eine Gußform zur Herstellung von Bond-Verbindungen;
- Figur 5: Die Gußform aus Figur 4, wobei leitendes Material in die Gußform eingefüllt worden ist;
- Figur 6: Die Gußform nach Figur 5, wobei ein Verfahrensschritt dargestellt wird, der die Gußform öffnet;
- Figur 7: Einen Verfahrensschritt nach Figur 6, bei dem die elektrischen Verbindungen an dem Schaltkreis und dem Träger angebracht werden;
- Figur 8: Ein weiterer Verfahrensschritt nach Figur 7, bei dem das Setzelement nach dem Bond-Prozeß von dem Schaltkreis und dem Träger entfernt wird.

In den Figuren bezeichnen gleiche Bezugszeichen gleiche oder funktionsgleiche Elemente.

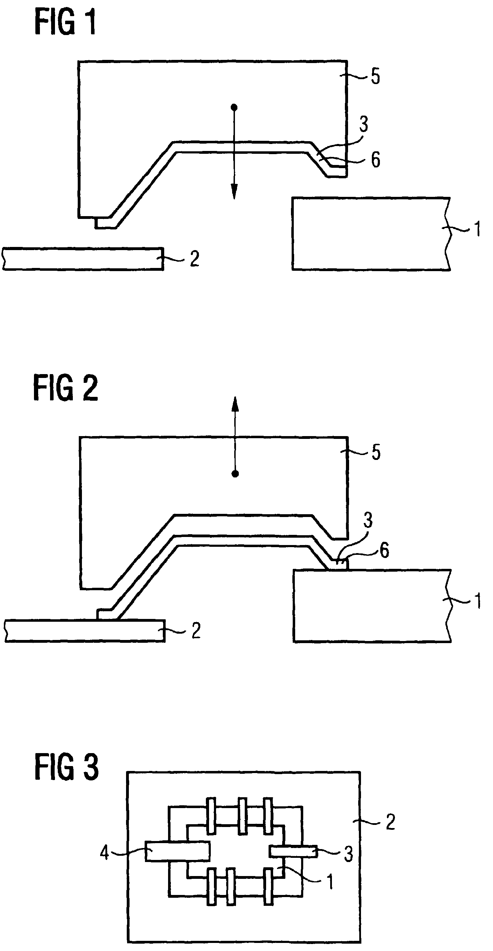

Mit Bezug auf Figur 1 ist eine erste Ausführungsform der erfindungsgemäßen Anordnung dargestellt. Der Schaltkreis 1 ist neben dem Träger 2 angeordnet. Bei dem Schaltkreis 1 kann es sich beispielsweise um einen auf einem Siliziumsubstrat hergestellten Schaltkreis handeln. Ebenso sind Substrate aus Galliumarsenid oder aus Dünnfilm-Materialien, wie sie beispielsweise zum Aufdampfen von TFT-(thin film transistor) Bauelementen verwendet werden, geeignet.
Bei dem Träger 2 handelt es sich beispielsweise um einen Leadframe. Ein Leadframe zeichnet sich durch leitfähige Bereiche aus, die zum Beispiel aus metallischen Leiterbahnen bestehen. Diese Leiterbahnen können zunächst noch verbunden sein, werden aber üblicherweise während der Herstellung eines gebondeten und gehäusten integrierten Schaltkreises voneinander getrennt.
Weiterhin kann es sich bei dem Träger 2 um einen Keramikträger handeln, auf dem mindestens ein integrierter Schaltkreis montiert werden kann. In oder auf dem Keramikträger, der üblicherweise ein isolierendes Grundmaterial darstellt, sind elektrisch leitende Bahnen angeordnet, die durch den Bond-Prozeß zumindest teilweise mit dem Schaltkreis 1 verbunden werden.
Ebenso ist es möglich, daß es sich bei dem Träger 2 um eine Leiterplatte handelt, die z.B. aus glasfaserverstärktem Kunsststoff gebildet ist. Die Leiterplatte kann als mehrlagiger Schichtstapel aus leitenden und isolierenden Schichten mit Leiterbahnen und Kontakten ausgestaltet sein. All diesen Trägermaterialien ist aber gemeinsam, daß sie leitfähige Bereiche aufweisen, die mit dem Schaltkreis zu kontaktieren sind. Die leitfähigen Bereiche bestehen zum Beispiel aus Metallen wie Kupfer, Aluminium, etc., die optional verzinnt sind.

Des weiteren ist ein Setzelement 5 oberhalb des Trägers 2 und oberhalb des Schaltkreises angeordnet. An der Unterseite des Setzelements 5 befindet sich dabei eine elektrische Verbindung 3, die aus einem leitenden Material 6 besteht. Bei dem leitenden Material 6 kann es sich beispielsweise um Gold, Kupfer oder Aluminium handeln. Auch sind Legierungen verwendbar, die Gold, Kupfer oder Aluminium enthalten. In Figur 1 ist mit dem Pfeil angedeutet, daß das Setzelement 5 an den Schaltkreis 1 und den Träger 2 angenähert wird.

Mit Bezug auf Figur 2 wird die elektrische Verbindung 3 mit dem Schaltkreis 1 und dem Träger 2 verbunden.

Die elektrische Verbindung 3 und verbindet den Schaltkreis 1 und den Träger 2 auch nachdem das Setzelement 5, wie durch den Pfeil angedeutet, von dem Schaltkreis 1 und dem Träger 2 entfernt wird.

In Figur 3 ist in Draufsicht ein Schaltkreis 1, ein Träger 2, eine elektrische Verbindung 3 zwischen dem Schaltkreis 1 und dem Träger 2 und eine weitere elektrische Verbindung 4 zwischen dem Schaltkreis 1 und dem Träger 2 dargestellt. Dabei können die einzelnen elektrischen Verbindungen mit unterschiedlichem Durchmesser, unterschiedlicher Höhe und unterschiedlicher Breite ausgeführt werden. Es ist z.B. möglich, stromtragende Leitungen mit einem größeren Querschnitt auszubilden, als andere Leitungen, bei denen in diesem Fall die Kosten durch einen geringen Leitungsquerschnitt gesenkt werden können.

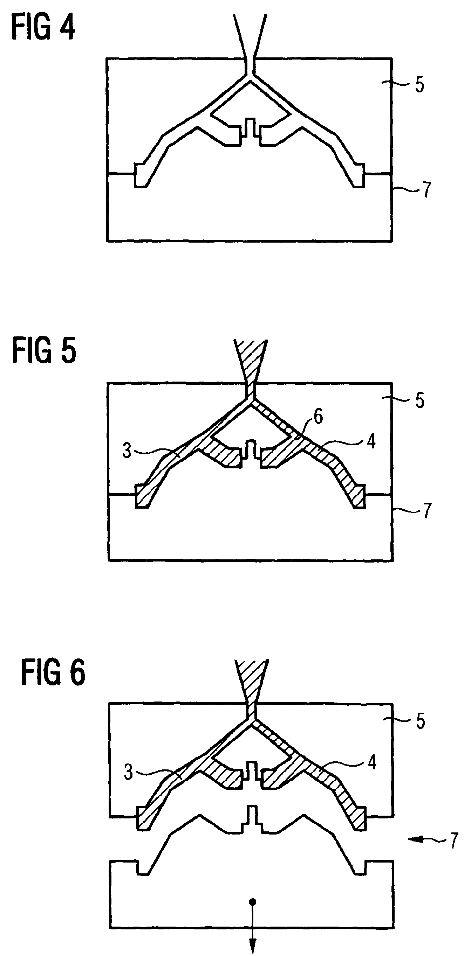

Mit Bezug auf Figur 4 wird ein Verfahren zur Herstellung einer ersten elektrischen Verbindung und der weiteren elektrischen Verbindung in einer Gußform 7 beschrieben. Die Gußform 7 besteht dabei teilweise aus dem Setzelement 5.

Mit Bezug auf Figur 5 wird das leitende Material 6 in den oben angedeuteten Trichter hineingefüllt und bildet so die elektrische Verbindung 3 und die weitere elektrische Verbindung 4.

Mit Bezug auf Figur 6 wird die Gußform 7 geöffnet, so daß die elektrische Verbindung 3 und die weitere elektrische Verbindung 4 an dem Setzelement verbleiben.

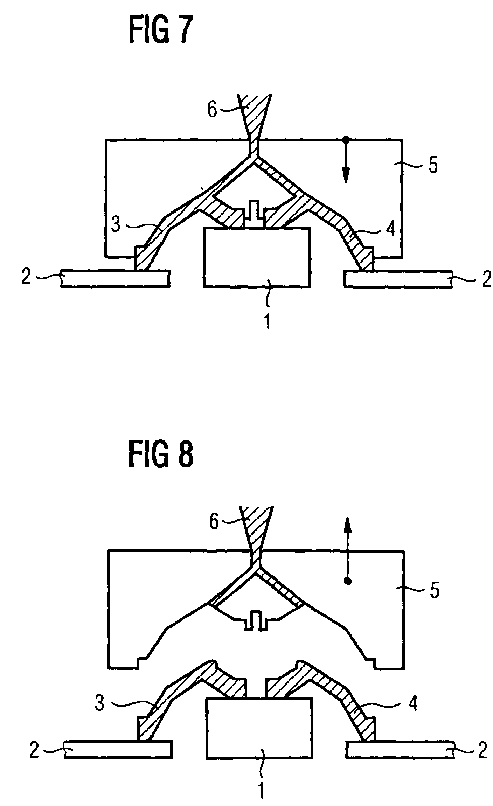

Mit Bezug auf Figur 7 wird nun das Setzelement 5 mit der elektrischen Verbindung 3 und der weiteren elektrischen Verbindung 4 auf den Schaltkreis 1 und den Träger 2 angedrückt und mittels Ultraschall, Druck und/oder Temperatur mit dem Schaltkreis 1 und dem Träger 2 verbunden.

Mit Bezug auf Figur 8 wird nach dem Bond-Prozeß das Setzelement von dem Schaltkreis 1 und dem Träger 2 entfernt, wobei die elektrische Verbindung 3 und die weitere elektrische Verbindung 4 als Bond-Verbindungen zwischen dem Schaltkreis 1 und dem Träger 2 verbleiben.

### Bezugszeichenliste

- 1: Schaltkreis
- 2: Träger
- 3: elektrische Verbindung
- 4: weitere elektrische Verbindung
- 5: Setzelement
- 6: Leitendes Material
- 7: Gußform

## Patentansprüche

1. Verfahren zum Kontaktieren eines Schaltkreises mit dem Schritt: anordnen eines Trägers (2) neben einem Schaltkreis (1)
**dadurch gekennzeichnet,** daß
ein Setzelement (5), an dem eine elektrische Verbindung (3) aus einem leitenden Material (6) haftet, an den Schaltkreis (1) und an den Träger (2) angenähert wird, so daß die elektrische Verbindung (3) den Schaltkreis (1) und den Träger (2) elektrisch verbindet.

2. Verfahren nach Anspruch 1,
**dadurch gekennzeichnet,** daß
alle elektrischen Verbindungen zwischen dem Schaltkreis (1) und dem Träger (2) gleichzeitig gebildet werden.

3. Verfahren nach einem der Anspräche 1 oder 2,
**dadurch gekennzeichnet,** daß
das leitende Material (6) in eine Gußform (7) eingebracht wird, um die elektrische Verbindung (3) zu bilden.

4. Verfahren nach Anspruch 3,
**dadurch gekennzeichnet,** daß
die Gußform (7), die mindestens aus zwei Formteilen besteht, wobei es sich bei einem Formteil um das Setzelement (5) handelt, in ihre Formteile zerlegt wird und die elektrische Verbindung (3) an dem Setzelement (5) verbleibt.

5. Verfahren nach einem der Ansprüche 1 bis 4,
**dadurch gekennzeichnet,** daß
die elektrische Verbindung (3) zwischen dem Schaltkreis (1) und dem Träger (2) mittels Andrücken des Setzelements (5) und/oder mittels Ultraschall und/oder mittels Temperatur hergestellt wird.

6. Verfahren nach einem der Ansprüche 5 bis 9,
**dadurch gekennzeichnet,** daß
das Setzelement (5) nach dem Bond-Prozeß von dem Schaltkreis
(1) und dem Träger (2) entfernt wird.

7. Anordnung zum Kontaktieren von Schaltkreisen nach einem der voranstehenden Verfahren mit:
- einem Schaltkreis (1);
- einem Träger (2), der neben dem Schaltkreis (1) angeordnet ist,
**dadurch gekennzeichnet,** daß
mindestens eine vorgeformte elektrische Verbindung (3) aus einem leitenden Material (6) den Schaltkreis (1) mit dem Träger (2) verbindet.

8. Anordnung nach Anspruch 7,
**dadurch gekennzeichnet,** daß
alle elektrischen Verbindungen zwischen dem Schaltkreis (1) und dem Träger (2) vorgeformte elektrischen Verbindungen sind.

9. Anordnung nach einem der Ansprüche 7 oder 8,
**dadurch gekennzeichnet,** daß
das leitende Material (6) zumindest teilweise aus Gold und/oder Kupfer und/oder Aluminium besteht.

10. Anordnung nach einem der Ansprüche 7 bis 9,
**dadurch gekennzeichnet,** daß
das leitende Material (6) in einer Gußform (7) angeordnet ist, wobei ein Teil der Gußform (7) aus dem Setzelement (5) besteht.
